# EUROPEAN PATENT APPLICATION

(11) **EP 4 177 371 A1**
(43) Date of publication of application: **10.05.2023**
(21) Application number: 21206177.4
(22) Date of filing: 03.11.2021
(51) Int. Cl.: C23C 16/04, C23C 16/455, B29C 64/159

(54) **AREA-SELECTIVE ATOMIC LAYER DEPOSITION METHOD**

(71) Applicant: Atlant 3D Nanosystems, 2800 Kongens Lyngby (DK)
(72) Inventor: KUNDRATA, Ivan, 2800 Kongens Lyngby (DK); WIESNER, Philipp, 2800 Kongens Lyngby (DK); PLAKHOTNYUK, Maksym, 2800 Kongens Lyngby (DK); BACHMANN, Julien, 2800 Kongens Lyngby (DK); CARNOY, Matthias, 2800 Kongens Lyngby (DK); FUNDING LA COUR, Mette, 2800 Kongens Lyngby (DK)
(74) Representative: V.O.

(57) **Abstract**

The disclosure relates to an atomic layer deposition method, comprising depositing a first layer of a first material at a selective first area of a substrate, and depositing a second layer of a second material at a selective second area of the substrate different from the first area. The first layer is deposited as a first line having a minimum first linewidth, and the second layer is deposited as a second line having a minimum second linewidth. The second layer is deposited partly on the first layer such that the first layer and the second layer partly overlap by a predetermined amount, or the first layer and the second layer are laterally spaced apart.

## Description

### FIELD

The invention relates to atomic layer deposition methods and the fabrication of nanostructures therewith.

### BACKGROUND

Atomic layer deposition, ALD, is a known technique for manufacturing nanoscale structures by depositing a thin film of a process material onto a substrate. ALD generally involves sequentially exposing a surface material, e.g. the substrate, to precursors and having the precursors react with the surface material.

In area-selective ALD, a thin layer of material is deposited at a selective and predetermined area of the substrate. This can be achieved using a particular deposition head that is arranged to only locally deposit a layer on the substrate. A continuous layer of material can be obtained by moving the deposing head relative to the substrate.

While in a Z-direction, i.e. transverse to a plane of the substrate, an atomic-scale resolution can be obtained, the in-plane resolution in an X-Y plane, i.e. parallel to the plane of the substrate, is limited, e.g. in the order of 50-400 micrometers.

### SUMMARY

Is it an aim to improve the in-plane resolution of area-selective atomic layer deposition methods.

According to an aspect, an atomic layer deposition method is provided, particularly an area-selective atomic layer deposition method. The method comprises depositing, using a first precursor fluid, a first layer on a substrate as a first line extending longitudinally and having, in lateral direction, a first linewidth; and depositing, using a second precursor fluid, a second layer on a substrate as a second line extending longitudinally and having, in lateral direction, a second linewidth. The first and second lines are deposited to partly overlap one another laterally by a predetermined amount such that, at the overlap, a first protrusion is formed of which a largest width, in lateral direction, is smaller than the first linewidth and the second linewidth. Alternatively, or additionally, the first and second lines are deposited to, at least partly, be laterally spaced apart from one another by a predetermined amount such that, at the spacing, a first recess is formed of which a largest width, in lateral direction, is smaller than the first linewidth and the second linewidth.

Hence, the method enables fabrication of, e.g. three-dimensional, features that have smaller widths, in an X-Y plane parallel to the substrate, than the in-plane resolution of the individual deposited layers. The method exploits accurate and precise positioning capabilities of the ALD head with respect to the substrate, when compared to the structural resolution of the individually deposited layers, to increase the spatial resolution of fabricated nanostructures. Variously shaped nanostructures can be created with the method, including, e.g. free-standing, protrusion and indentations, such as linear and/or curved ridges or linear and/or curved grooves, having a dimension in the X-Y plane that is substantially smaller than the X-Y dimensions of the individual first and second layers that form the protrusions and indentations.

For example, at the overlap of the first and second layer, a projection can be formed having a smaller width than the width of the first layer and the second layer. Also, a recess can be formed at the gap between two adjacent layers, the gap having a smaller width than the width of the first layer and the second layer. Various nanostructures can be fabricated this way, e.g. using a plurality of superimposed layers.

Each deposited line may have a minimum width. The minimum width of a line may be defined in a direction transverse to a longitudinal direction of the line, which longitudinal direction may correspond to a depositing direction, e.g. a printing direction. The depositing direction may particularly relate to a direction in which an ALD head is moved relative to the substrate, while deposing material. The minimum width may be considered as a smallest linewidth of a deposited line. More particular, the minimum width may be considered as a smallest practically achievable linewidth an area-selective ALD system is capable of producing. It will be appreciated that the deposited line can have a substantially constant width.

The layers can be deposited using an ALD system having an ALD printer head, such as for example described in WO2020/245230A1, incorporated herein by reference. The ALD head can be moved relative to the substrate to deposit multiple lines in various patterns, so as to create a variety of nanostructures including nanopillars, nanoridges and nanoholes, for example for use in fabricating micro- and nanoscale electro-mechanic, opto-electronic, and opto-mechanic systems, or combinations thereof.

The first layer and the second layer may overlap each other in part. Hence, the overlap between the first line and the second line extends to only a part of the first line and also to only a part of the second line. Hence, the overlap does not extend to the entire first line or the entire second line. For example, if only part of the second line covers the first line, only a part of the first line is be covered by the second line. The first line for example includes an overlapping area where the first line is covered by the second line, and a non-overlapping area where the first line is not covered by the second line. The second line may thus, in this example, include an overlapping area where the second line covers the first line, and a non-overlapping area where the second line does not cover the first line.

The amount of overlap can be predetermined, yet does not include a line in its entirety. The amount of overlap may be adjusted, for example, by positioning the ALD head appropriately.

Optionally, the largest width of the first protrusion or first recess is at most 50% of the first or second linewidth, preferably at most 25%, more preferably at most 10%, more preferably at most 5%.

Optionally, the first line and the second line extend parallel to one another, at least along a part of their length, for forming an elongate first protrusion and/or first recess. Hence, a narrow ridge or narrow groove can be fabricated, wherein the ridge is formed at the overlap of the first and the second line and the groove at the gap between the first and the second line. For example, the first layer and the second layer may be consecutively deposited as parallel lines that extend in a longitudinal direction and partly overlap each other in a width direction transverse to the longitudinal direction; the second layer partly overlapping the first layer, or vice versa. Alternatively, the first layer and the second layer may be consecutively or simultaneously deposited as parallel lines that extend in a longitudinal direction and are spaced apart from each other in a width direction transverse to the longitudinal direction. The first and second line may be straight and/or curved.

One or more further lines may, for example, also be deposited, e.g. overlapping the second line for creating a further ridge. This way, a plurality of parallel ridges and/or grooves can be formed, each ridge or groove having a width that is smaller than a width of the individual deposited lines.

The first layer and the second layer may also be deposited as non-parallel lines, for example as curved lines that partly overlap in one or more locations.

Optionally, the first layer is deposited as a first line having a constant first linewidth, and the second layer is deposited as a second line having a constant second linewidth. The first linewidth may be equal to the second linewidth. The linewidths may also differ. The linewidths are defined in the X-Y plane, particularly in a direction transverse to the length direction of the lines, e.g. determined by a printing direction, and are dependent on the characteristics of the depositing head.

Optionally, the first line comprises a straight line section and/or the second line comprises a straight line section. The first line and the second line may for example extend straight and parallel to each other.

Optionally, the first layer is of a first material and the second layer is of a second material different from the first material. Hence, multi-material structures can be formed, such as, for example, forming electrically conductive or insulative paths for directing a transport of charges, or forming photo-active surfaces for generating and transporting charge carriers. By using different materials, electronic, mechanical, and optical properties of the resultant nanostructure can be adjusted.

Optionally, the first layer of the first material is deposited at a first temperature, and the second layer of the second material is deposited at a second temperature, different from the first temperature.

Optionally, the method comprises depositing, using a third precursor fluid, a third layer. The third layer may be deposited as a third line extending longitudinally and having, in lateral direction, a third linewidth, wherein the third line is deposited to partly overlap the second line laterally by a predetermined amount such that, at the overlap with the second line, a second protrusion is formed of which a largest width is smaller than the first, second and third linewidth. The third line may be similar to the first line or second line. Hence, any features described in relation to the first line or second line, can equally apply to the third line.

For example, the first, second and third layers may be consecutively deposited as parallel lines that extend in a longitudinal direction and partly overlap each other in a width direction transverse to the longitudinal direction; the second layer partly overlapping the first layer, the third layer partly overlapping the second layer. The amount of overlap can be predetermined, for example by positioning the ALD head appropriately while depositing the layers.

Optionally, the width of the second protrusion is equal to the width of the first protrusion. Hence, a regular pattern of overlapping layers may be formed, e.g. for forming ridges.

Optionally, the third layer partly overlaps the first layer by a predetermined amount. Hence, the third layer may overlap the second layer as well as the first layer, for example for forming a stepped structure. It will be appreciated that the third layer need not contact the first layer. The third layer may for example be deposited on part of the second layer, which second layer has been deposited on part of the first layer. An overlapping area may for example exist where the first, second and third layers are overlapping; forming a stack of layers at the overlap.

Optionally, the amount of overlap between the third layer and the first layer is smaller than the amount of overlap between the first layer and the second layer. Hence a stepped structure may be created.

Optionally, a lateral distance between the first protrusion and the second protrusion is smaller than the first, second or third linewidth. Hence, multiple nanostructures, e.g. multiple ridges, can be manufactured in a space (X and/or Y) smaller than a minimum linewidth of the ALD head.

Optionally, the third line is laterally spaced apart from the first line. The third line may, thus, not overlap the first line. This way, a recess may be created, defined between an overlapping area where first and the second lines overlap and an overlapping area where the second and the third lines overlap, which recess has a width, in lateral direction, smaller than the first, second or third linewidth.

Optionally, the method comprises depositing, using a fourth precursor fluid, a fourth layer, the fourth layer being deposited as a fourth line extending longitudinally and having, in lateral direction, a fourth linewidth, wherein the fourth line is deposited, at least partly, laterally spaced apart from the second line by a predetermined amount such that, at the spacing between the fourth and the second line, a second recess is formed which second recess has a largest width which is smaller than the first, second and fourth linewidth. Hence, the fourth line may be spaced from the second line, wherein the second line may partly overlap or be spaced from the first line. For example, the first, second and fourth layers may be consecutively deposited as parallel lines that extend in a longitudinal direction wherein the first and second lines partly overlap each other in a width direction transverse to the longitudinal direction; the second line partly overlapping the first line, and the fourth line laterally spaced apart from the second line in the width direction to define a gap between the fourth and the second line with a gap width smaller than a minimum width of any of the deposited lines. Alternatively, for example, the first, second and fourth layers may be consecutively or simultaneously deposited as parallel lines that extend next to each other in a longitudinal direction, wherein the first, second, and fourth layers are laterally spaced apart from each other in a width direction transverse to the longitudinal direction. The spacing between consecutive layers may for example be equal to create a regular pattern of indentations.

It will be appreciated that the ALD method can include depositing multiple first, second, third and/or fourth layers according to a thickness requirement in the Z direction transverse to the plane of the substrate.

The method for example includes stacking multiple first layers in the Z direction and/or stacking multiple second layers in the Z-direction. Edge deviations of the individual layers of the stack may result in slightly inclined edges of the nanostructure. Mutual offset or overlap of the inclined edges can be used for manufacturing a recess or protrusion. For example, a recess may be formed between a stack of first layers and a stack of second layers. When stacking multiple identical width layers in the Z direction, deviations in lateral alignment can be used for shaping the form of the side walls of the nanostructure. The form of the side walls of the nanostructure can also be shaped by stacking multiple lines of differing widths.

Optionally, the ALD method comprises, after depositing the first, the second, the third and/or the fourth layer(s), selectively removing at least in part any one of the first, second, third or fourth layers. This way, cavities in the nanostructure can for example be formed. One or more of the deposited layers may be a sacrificial layer, arranged for being removed. A layer may for instance be removed by etching. Material-selective etching may be used, for example in case deposited layers are of respectively different materials.

According to a further aspect, an atomic layer deposition method is provided comprising depositing, using a fifth precursor fluid, a fifth layer on a substrate as a fifth line extending longitudinally and having, in lateral direction, a fifth linewidth; depositing, using a sixth precursor fluid, a sixth layer on a substrate as a sixth line extending longitudinally and having, in lateral direction, a sixth linewidth; the fifth and sixth lines extending longitudinally in different directions than the first and second lines. The fifth and/or sixth line can e.g. extend orthogonal, at an angle, or otherwise in a different direction, relative to the first and/or second line. The fifth and sixth lines are deposited to partly overlap one another laterally by a predetermined amount such that, at the overlap, a third protrusion is formed of which a largest width, in lateral direction, is smaller than the fifth linewidth or the sixth linewidth; and/or wherein the fifth and sixth lines are deposited to, at least partly, be laterally spaced apart from one another by a predetermined amount such that, at the spacing, a third recess is formed of which a largest width, in lateral direction, is smaller than the fifth linewidth or the sixth linewidth. It will be appreciated that the ALD method can include depositing multiple first, second, third, fourth, fifth and/or sixth layers according to a thickness requirement in the Z direction transverse to the plane of the substrate.

According to another aspect, a nanostructure is provided obtainable by an atomic layer deposition method as described herein.

In particular, a nanostructure is provided obtainable by atomic layer deposition in which material layers are deposited as material lines extending longitudinally and having, in lateral direction, a linewidth, wherein the nanostructure comprises a material structure having a largest width, in lateral direction, being smaller than the linewidth of the material lines.

Optionally, the nanostructure comprises a first layer, being deposited, using a first precursor fluid, as a first line extending longitudinally and having, in lateral direction a first linewidth; and a second layer, being deposited, using a second precursor fluid, as a second line extending longitudinally and having, in lateral direction, a second linewidth. The first line and the second line partly overlap each other laterally by a predetermined amount such that, at the overlap, a first protrusion is formed of which a largest width, in lateral direction, is smaller than the first linewidth and the second linewidth; and/or the first layer and the second layer are, at least partly, laterally spaced apart from one another by a predetermined amount such that, at the spacing, a recess is formed of which a largest width, in lateral direction, is smaller than the first linewidth and the second linewidth.

According to an aspect, an atomic layer deposition method is provided, for example in accordance with any method described herein. The method comprises depositing a plurality of layers as parallel lines that extend longitudinally and at least partly overlap each other in longitudinal direction, wherein the ends of the lines are shifted with respect to each other in longitudinal direction by a predetermined amount so as to create a material layer having a variable thickness in longitudinal direction. For example, the respective lines can have different lengths and/or be shifted relative to each other. Hence, the superimposed lines may create a step-wise increasing and/or decreasing thickness of material layer in longitudinal direction. The material thickness may for example be a gradually increasing or decreasing.

It will be appreciated that the methods described herein may be executed using an atomic layer deposition system. An exemplary ALD system may comprise a substrate plate for holding a substrate, and an ALD head, e.g. a printer head, positioned opposite the substrate plate. The ALD head may comprise a number of openings, e.g. provided in a head plate, including one or more first exit openings and one or more first supply channels connected to the one or more first exit openings for guiding a first precursor fluid onto the substrate through the one or more first exit openings. The system may also comprise one or more second exit openings and one or more second supply channels connected to the one or more second exit openings for guiding a second precursor fluid onto the substrate through the one or more second exit openings. The system may also comprise one or more third exit openings and one or more third supply channels connected to the one or more third exit openings for guiding an inert fluid onto the substrate through the one or more third exit openings.

The ALD head may be movable relative to the substrate plate, e.g. along an axis, in an X-Y plane defined by an X axis and an Y axis being perpendicular in relation to each other, and optionally along a Z axis being perpendicular to the X-Y plane.

It will be appreciated that any one or more of the aspects, features and options described herein can be combined. In particular, it will be appreciated that any of the aspects, features, and options described in view of the atomic layer deposition method apply equally to the nanostructure.

### BRIEF DESCRIPTION OF THE DRAWINGS

Embodiments of the present invention will now be described in detail with reference to the accompanying drawings in which:
Figures 1A and 1B shows schematic cross-sectional views of exemplary nanostructures formed by an atomic layer deposition method;
Figure 2 shows a schematic cross-sectional view of an exemplary nanostructure formed by an atomic layer deposition method;
Figure 3 shows a schematic cross-sectional view of an exemplary nanostructure by an atomic layer deposition method;
Figures 4A-4C schematically shows a formation of an exemplary nanostructure using an atomic layer deposition method;
Figure 5 shows an image of an exemplary nanostructure;
Figure 6 shows an image of an exemplary nanostructure;
Figure 7 shows an image of an exemplary nanostructure;
Figure 8 shows an image of an exemplary nanostructure; and
Figure 9 shows an image of an exemplary nanostructure.

### DETAILED DESCRIPTION

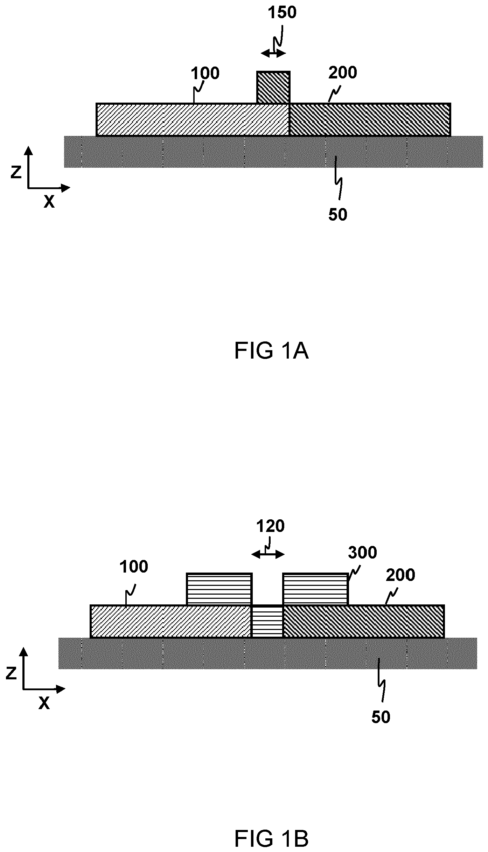

Figures 1A and 1B show schematic cross-sectional views of exemplary nanostructures obtained by an atomic layer deposition (ALD) method, in which a substrate 50 is provided and wherein a first layer 100 is deposited at a selective first area of the substrate 50. The first layer 100 may for example be deposited using a deposition head, for example as described in WO2020/245230A1.

In this example, the first layer 100 has an atomic-scale thickness, measured in a Z-direction. In a plane of the substrate (X-Y plane), the first layer 100 has a first width, here measured in the X-direction. In this example, the first width is about 50 micrometer.

After depositing the first layer 100, a second layer 200 is deposited at a selective second area of the substrate different from the first area where the first layer 100 has been deposited. In this example, the second layer 200 has an atomic-scale thickness, measured in a Z-direction. In a plane of the substrate (X-Y plane), the second layer 200 has a second width, here measured in the X-direction. In this example, the second width is about 50 micrometer.

In the example of figure 1A, the second layer 200 overlaps, in part, the first layer 100. Hence, an overlapping area 150 is formed between the first 100 and the second layer 200. As the first and the second layers 100, 200 only partly overlap, the first and the second layers 100, 200 also include a non-overlapping area where the layers do not overlap.

At the overlapping area 150, a thickness of the deposited material corresponds to the sum of the first layer thickness, and the second layer thickness. Hence, at the overlapping area 150, a protrusion 160 is formed. Outside of the overlapping area 150 the thickness of the deposited material is smaller, e.g. either the thickness of the first or the second layer.

A width of the protrusion 160 in the X-direction, can be adapted for example by positioning the ALD head accordingly relative to the first layer when depositing the second layer. The width of the protrusion, formed by the overlapping layers, is smaller than the respective widths of the first and second layers 100, 200.

In this example, the first layer 100 and the second layer 200 are deposited as a first line and second line respectively that extend in longitudinal direction into the plane of Figure 1, here the Y-direction. The width of the layers, in the X-direction, is substantially fixed and depends on the characteristics of the deposition head. A line structure may be deposited by moving the deposition head relative to the substrate 50 in the longitudinal direction, while depositing material. Hence a length, in the Y-direction, of the first layer can be adapted, by the relative motion between the substrate 50 and the deposition head. Hence, in this example, the overlapping area 150 forms a ridge that extends in a longitudinal direction into the plane of figure 1. It will be appreciated that the nanostructure can include multiple first and second layers stacked according to a thickness requirement in the Z direction.

In figure 1B, the first layer 100 and the second layer 100 are spaced apart from one another so as to form a gap 120 between the layers. The gap 120 has a gap width that is less than a width of each of the first 100 and second layers 200. The gap width may be predetermined, e.g. using the ALD head. Hence, between the first and the second layers 100, 200 a recess 170 is formed.

In this example, a third layer 300 is also deposited, which third layer 300, here, overlaps the first layer 100, as well as the second layer 200. In this example, a recess is formed between the two overlapping areas, i.e. between the overlapping area of the third layer 300 with the first layer 100 and the overlapping area of the third 300 with the second layer 200. The width of the recess is equal to the gap width. It will be appreciated that the nanostructure can include multiple first, second and third layers stacked according to a thickness requirement in the Z direction.

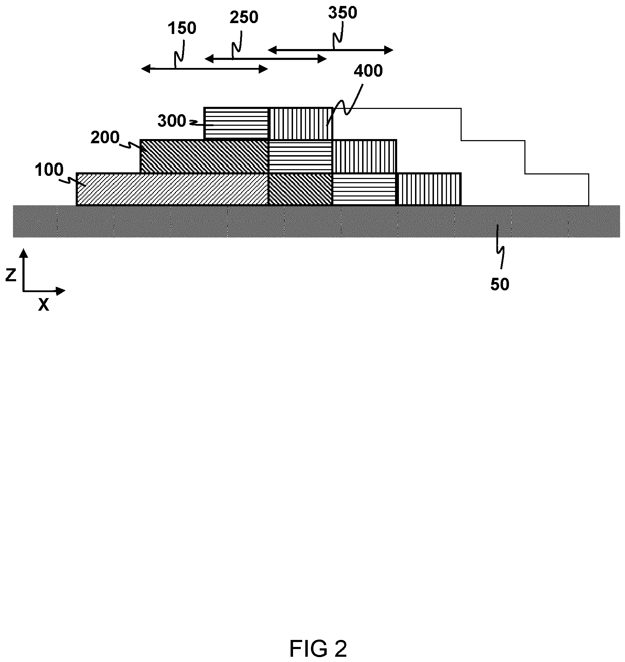

Figure 2 shows a schematic cross-sectional view of another exemplary nanostructure obtained by an atomic layer deposition (ALD) method, similar to the nanostructure as shown in figure 1. In this example, the overlapping area 150 between the first layer 100 and the second layer 200 is larger compared to the overlapping area 150 of the example as shown in figure 1. Furthermore, a third layer 300 is deposited, which third layer 300 overlaps, in part, the second layer 200. In this example, the overlapping area 150 is equal to the overlapping area 250 of the third layer 300 with the second layer 200, for creating a regular pattern. Also, in this example, the third layer 300 overlaps in part the first layer 100. Hence, at an overlap of the overlapping areas 150 and 250, the first, second and third layers are stacked in the Z-direction.

Further, a fourth layer 400 is deposited, which fourth layer 400 similarly overlaps, in part, the third layer 300 with an overlapping area 350, here, equal to the previously described overlapping areas 150 and 250, and also partly overlapping the second layer 200. It will be appreciated that the nanostructure could be extended by adding more layers. It will be appreciated that the nanostructure can include multiple first, second and third layers stacked according to a thickness requirement in the Z direction.

Hence, an array of overlapping layers is deposited which form a nanostructure having substantially flat top surface, and a, e.g. regularly, stepped edge.

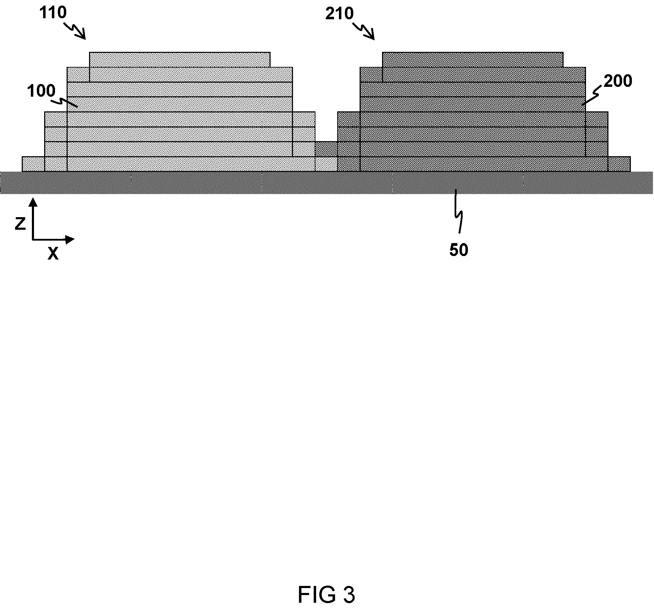

Figure 3 shows an exemplary nanostructure wherein multiple first layers 100, and multiple second layers 200 are stacked in the Z direction, forming respectively a first stack 110 and a second stack 210. The second stack 210 of stacked second layers 200 partly overlaps the first stack 110 of stacked first layers 100 in this example. Edge deviations of the individual layers of each stack may result in slightly inclined edges of the stacks.

Deviations in lateral alignment of the layers of a stack of layers, can be used for shaping the form of the side walls of the nanostructure. The individual layers of a stack may for example be laterally misaligned with respect to each other. Various nanostructures can be created by partly overlapping stacks of layers with each other..

In the example shown in figure 3, the first stack 110 includes eight first layers 100, and the second stack 210 includes eight identical width second layers 200, wherein the second stack 210 partly overlap the first stack 110. A recess is formed between the two stacks, having a varying width with respect to the Z direction.

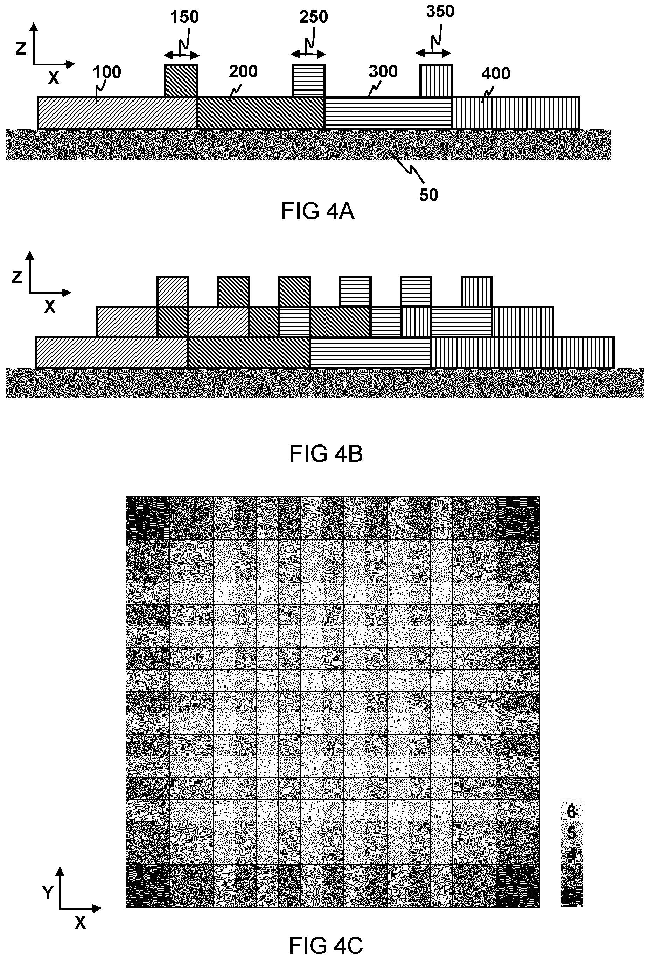

Figures 4A-4C show an exemplary ALD method, in which, in a first stage, shown in figure 4A, a plurality of, here four, layers are consecutively and overlappingly deposited as lines that extend longitudinally in the Y-direction. Here, the lines extend parallel and into the plane of the figure. Each line is deposited partly on top of a previously deposited line. Hence, each line overlaps in part an adjacent line in lateral direction, here the X-direction, wherein at the overlapping areas an array of, in this example three, parallel ridges is formed, each ridge having a width that is much smaller than the linewidth of the deposited lines.

In a second stage of the exemplary method, shown in figure 4B, a further plurality of, here four, layers are deposited, also as lines that extend longitudinally in the Y-direction, on top of the layers that have been deposited in the first stage. More particular, in this example, the first stage and the second stage of the method are identical, but in the second stage, the lines have shifted laterally, in the X-direction, by a predetermined amount, such that an array of parallel ridges is created in between the ridges that had been formed in the first stage of the method. Hence, in this example two ridges are created within the width of a single deposited line. More in general, it will be appreciated that with this method multiple (e.g. 2, 3, 4, 5, 6, 8, 10, 20 or more) nanostructures, e.g. multiple ridges or other structures, can be manufactured in a space (X and/or Y) smaller than a minimum linewidth of the ALD head.

In this example, a third and a fourth stage of the exemplary method, substantially repeat the first and the second stage respectively, wherein the longitudinal orientation of the deposited lines is changed, in this example rotated 90 degrees about the Z-axis. Hence, in this example, in the first and the second stage, the lines are deposited as lines extending longitudinally in the Y-direction, whereas in the third and fourth stage the lines are deposited as lines extending longitudinally in the X-direction. It will be appreciated that, instead of transverse, other orientations of the lines in the third and fourth stage are also possible.

Figure 4C shows a schematic height-map of the superimposed lines. A nanostructure is created having a varying thickness profile. In this example, a lattice, in the X-Y plane, of regularly distributed free-standing nanopillars is formed, wherein a width dimension, in the X-Y plane, of each nanopillar is much smaller than the width dimension of the individually deposited lines. The nanopillars are, in this example, formed by a stack of six layers. The nanopillars are particularly formed at a crossing of ridges, wherein each ridge has a smaller width than any one of the deposited lines. It will be clear that in the example of Figures 4A-4C the steps of the method can be repeated, e.g. identically, for increasing a thickness of the structure in the Z direction.

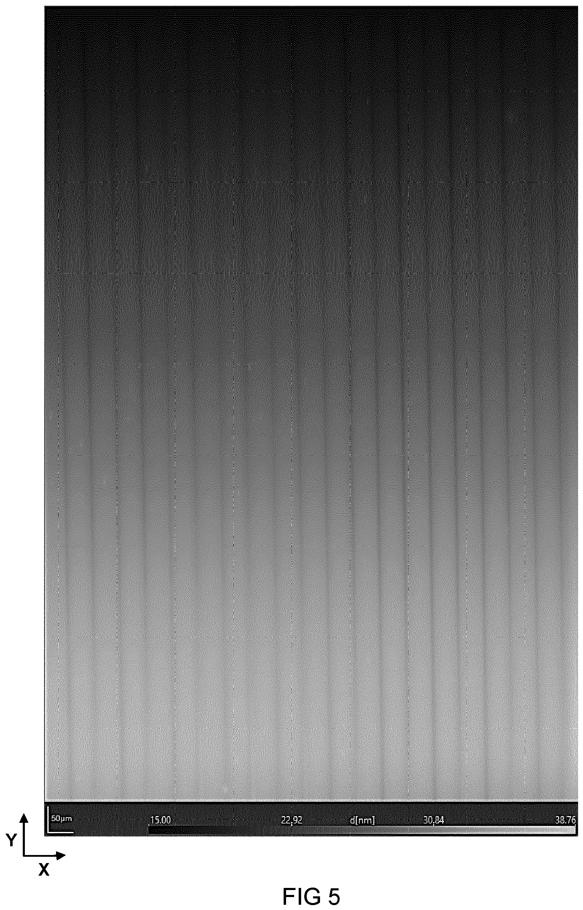

Figure 5 shows an imaging ellipsometry map of an exemplary nanostructure formed by an array of layers being deposited as parallel non-overlapping lines, wherein between each of the lines, a recess is formed that is much smaller than a linewidth of the individually deposited lines. Further, in this example, a material-gradient is applied in the direction in which the deposited lines extend. Here, the length of the deposited lines in the Y-direction gradually decreases, resulting in gradually changing thickness of the material. Hence, in this example, the nanostructure is given a sloping face. It will be appreciated that the lines of gradually decreasing length may be deposited in any desired order for obtaining the gradually changing thickness of the material.

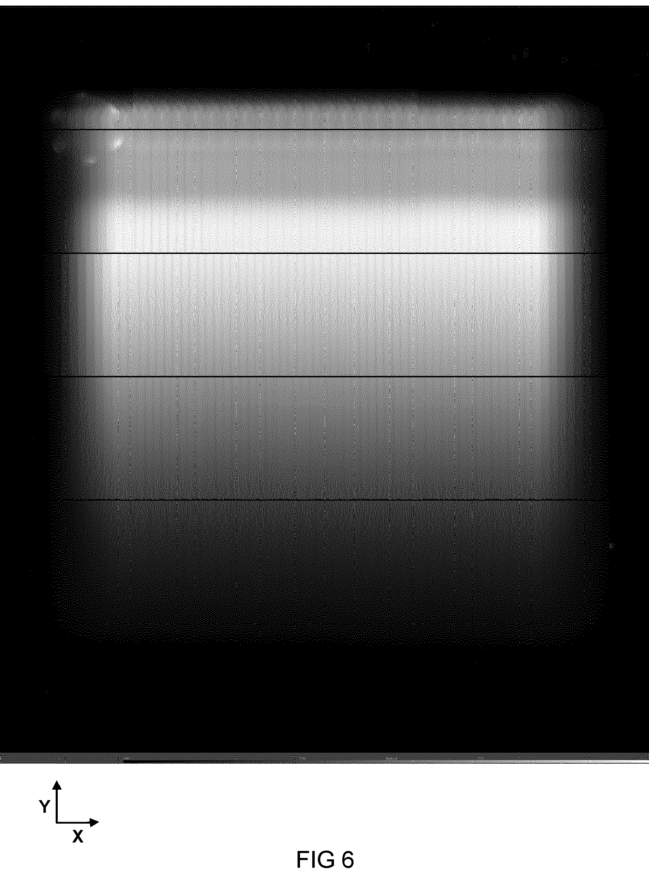

Figure 6 shows an imaging ellipsometry map of an exemplary nanostructure formed by an array of partly overlapping layers. The deposited layers are deposited as partly overlapping parallel lines, extending in a single direction. At the left and right edges, a stepped increase in the thickness of the deposited structure can be seen, with a plateau of constant thickness in X-direction in between. In this example, from the left and right edges, the plateau is reached in eight thickness steps. In this example the width of these eight thickness steps corresponds to the linewidth of a single deposited line. Also in Figure 6 the deposited structure displays a gradually changing thickness of the material in the Y-direction. Further, dark colored lines in the Y-direction indicate where a gap is present between adjacent lines, forming a recess in the deposited structure.

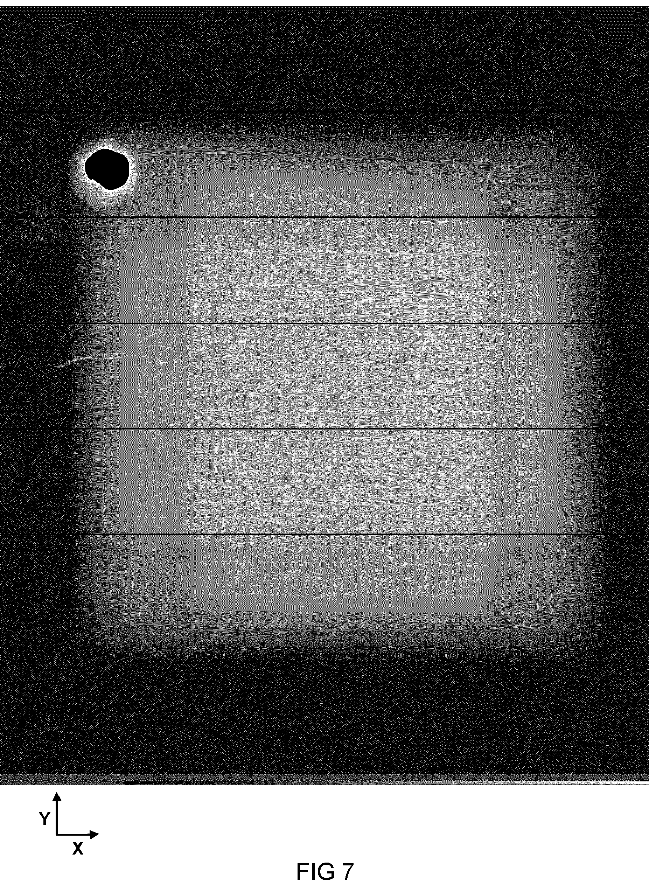

Figure 7 shows a heightmap image of an exemplary nanostructure formed by an array of partly overlapping layers. The deposited lines extend in two transverse directions, similar to as explained in conjunction to figures 4A-4C, creating a raster-like structure of protrusions and indentations. In this example, at the left, right, top and bottom edges, a stepped increase in the thickness of the deposited structure can be seen, with a plateau of constant thickness in between. In this example, from the left, right, top and bottom edges, the plateau is reached in eight thickness steps. In this example the width of these eight thickness steps corresponds to the linewidth of a single deposited line. Further, light colored lines in the X-direction and Y-direction indicate where a ridge is at the plateau, formed by specific overlap of the deposited lines.

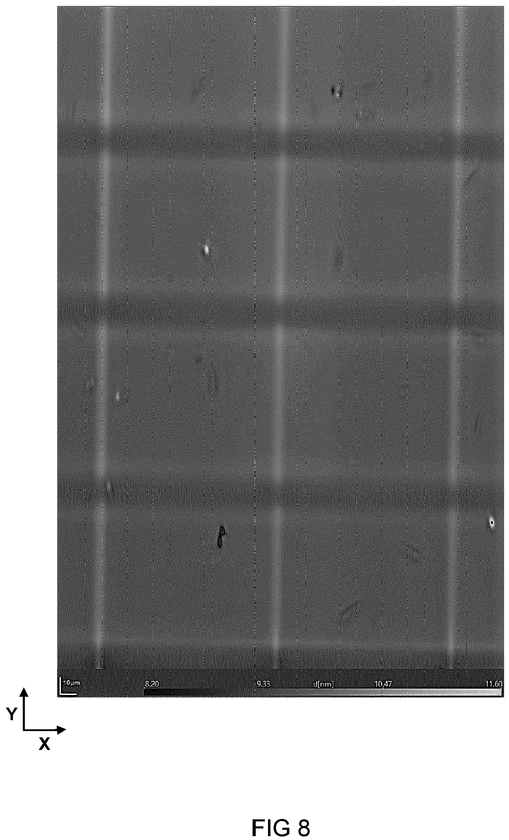

Figure 8 shows an imaging ellipsometry map of a close-up nanostructure, having a raster-like pattern of protrusions (light colored lines) and indentations (dark colored lines) similar to the nanostructure as shown in figure 7.

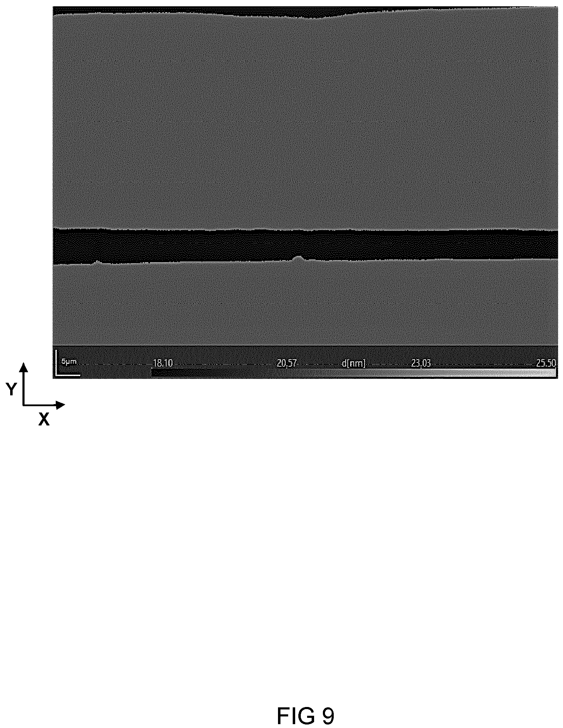

Figure 9 shows another imaging ellipsometry map of a close-up of a nanostructure, particular of a gap area between consecutively deposited atomic lines.

Herein, the invention is described with reference to specific examples of embodiments of the invention. It will, however, be evident that various modifications and changes may be made therein, without departing from the essence of the invention. For the purpose of clarity and a concise description features are described herein as part of the same or separate embodiments, however, alternative embodiments having combinations of all or some of the features described in these separate embodiments are also envisaged.

Although in the examples, layers are deposited as straight lines, it will be appreciated that alternatively, or additionally, curved lines can be deposited. It will also be possible that lines may deposited which overlap and/or are spaced apart along a portion of their length.

However, other modifications, variations, and alternatives are also possible. The specifications, drawings and examples are, accordingly, to be regarded in an illustrative sense rather than in a restrictive sense.

For the purpose of clarity and a concise description features are described herein as part of the same or separate embodiments, however, it will be appreciated that the scope of the invention may include embodiments having combinations of all or some of the features described.

In the claims, any reference signs placed between parentheses shall not be construed as limiting the claim. The word 'comprising' does not exclude the presence of other features or steps than those listed in a claim. Furthermore, the words 'a' and 'an' shall not be construed as limited to 'only one', but instead are used to mean 'at least one', and do not exclude a plurality. The mere fact that certain measures are recited in mutually different claims does not indicate that a combination of these measures cannot be used to an advantage.

## Claims

1. Atomic layer deposition method comprising
depositing, using a first precursor fluid, a first layer on a substrate as a first line extending longitudinally and having, in lateral direction, a first linewidth;
depositing, using a second precursor fluid, a second layer on the substrate as a second line extending longitudinally and having, in lateral direction, a second linewidth;
wherein the first and second lines are deposited to partly overlap one another laterally by a predetermined amount such that, at the overlap, a first protrusion is formed of which a largest width in lateral direction, is smaller than the first linewidth and the second linewidth; and/or
wherein the first and second lines are deposited to, at least partly, be laterally spaced apart from one another by a predetermined amount such that, at the spacing, a first recess is formed of which a largest width, in lateral direction, is smaller than the first linewidth and the second linewidth.

2. Method of claim 1, wherein the largest width of the first protrusion or first recess is at most 50% of the first or second linewidth, preferably at most 25%, more preferably at most 10%, more preferably at most 5%.

3. Method of claim 1 or 2, wherein the first line and the second line extend parallel to one another for forming an elongate first protrusion and/or first recess.

4. Method of any preceding claim, wherein the first line and the second line have a constant and optionally equal linewidth.

5. Method of any preceding claim, wherein the first line comprises a first straight line section and/or the second line comprises a second straight line section.

6. Method of any preceding claim, wherein the first layer is of a first material, and the second layer is a second material different from the first material.

7. Method of any preceding claim, comprising depositing, using a third precursor fluid, a third layer, the third layer being deposited as a third line extending longitudinally and having, in lateral direction, a third linewidth, wherein the third line is deposited to partly overlap the second line laterally by a predetermined amount such that, at the overlap with the second line, a second protrusion is formed of which a largest width is smaller than the first, second and third linewidth.

8. Method of claim 7, wherein the width of the second protrusion is equal to the width of the first protrusion.

9. Method of claim 7 or 8, wherein a lateral distance between the first protrusion and the second protrusion is smaller than the first, second or third linewidth.

10. Method of claim 7, 8 or 9, wherein the third line is, at least partly, laterally spaced apart from the first line by a predetermined amount.

11. Method of any of claims 1-10, comprising depositing, using a fourth precursor fluid, a fourth layer, the fourth layer being deposited as a fourth line extending longitudinally and having, in lateral direction, a fourth linewidth, wherein the fourth line is deposited, at least partly, laterally spaced apart from the second line by a predetermined amount such that, at the spacing between the fourth and the second line, a second recess is formed which recess second recess has a largest width which is smaller than the first, second and fourth linewidth.

12. Method of any preceding claim, comprising, after depositing the first, the second, the third and/or the fourth layer, selectively removing, at least in part, any one of the first, second, third or fourth layers.

13. Method of any preceding claim, comprising
depositing, using a fifth precursor fluid, a fifth layer on a substrate as a fifth line extending longitudinally and having, in lateral direction, a fifth linewidth;
depositing, using a sixth precursor fluid, a sixth layer on a substrate as a sixth line extending longitudinally and having, in lateral direction, a sixth linewidth;
the fifth and sixth lines extending longitudinally in different directions than the first and second lines;
wherein the fifth and sixth lines are deposited to partly overlap one another laterally by a predetermined amount such that, at the overlap, a third protrusion is formed of which a largest width, in lateral direction, is smaller than the fifth linewidth or the sixth linewidth; and/or
wherein the fifth and sixth lines are deposited to, at least partly, be laterally spaced apart from one another by a predetermined amount such that, at the spacing, a third recess is formed of which a largest width, in lateral direction, is smaller than the fifth linewidth or the sixth linewidth.

14. Nanostructure obtainable by atomic layer deposition in which material layers are deposited as material lines extending longitudinally and having, in lateral direction, a line width, the nanostructure including a material structure having a largest width, in lateral direction, which a smaller width than the line width of the material lines.

15. Nanostructure according to claim 14, comprising
a first layer, being deposited, using a first precursor fluid, as a first line extending longitudinally and having, in lateral direction a first linewidth; and
a second layer, being deposited, using a second precursor fluid, as a second line extending longitudinally and having, in lateral direction, a second linewidth,
wherein the first line and the second line partly overlap one another laterally by a predetermined amount such that, at the overlap, a protrusion is formed of which a largest width, in lateral direction, is smaller than the first linewidth and the second linewidth; or
wherein the first layer and the second layer are, at least partly, laterally spaced apart from one another by a predetermined amount such that, at the spacing, a recess is formed of which a largest width, in lateral direction, is smaller than the first linewidth and the second linewidth.
